# EUROPEAN PATENT APPLICATION

(11) **EP 4 590 080 A1**
(43) Date of publication of application: **23.07.2025**
(21) Application number: 22958799.3
(22) Date of filing: 15.09.2022
(51) Int. Cl.: H05K 3/28

(54) **RESIN LAMINATE FORMATION DEVICE AND RESIN LAMINATE FORMATION METHOD**

(71) Applicant: Fuji Corporation, Chiryu-shi, Aichi 472-8686 (JP)
(72) Inventor: HIRAMATSU, Naohiko, Chiryu-shi, Aichi 472-8686 (JP)
(74) Representative: Grünecker Patent- und Rechtsanwälte PartG mbB
(86) International application number: PCT/JP2022/034542
(87) International publication number: WO 2024/057475

(57) **Abstract**

A resin laminate formation device including an ejection device configured to eject a curable resin into a film shape to cover an upper surface of a component mounted in a cavity formed in a base and to cover an upper surface of the base, the component having a height dimension longer than a depth dimension of the cavity; and a planarization device configured to planarize the curable resin ejected from the ejection device at a set height which is set at a position higher than the upper surface of the component in a state of being mounted in the cavity, in which ejection of the curable resin from the ejection device and planarizing by the planarization device are repeatedly performed, whereby a resin laminate having an upper surface height with the set height is formed on the base by laminating the film-shaped curable resin.

## Description

### Technical Field

The present invention relates to a resin laminate formation device and a resin laminate formation method.

### Background Art

Patent Literature 1 below describes a technique related to a circuit board including an electronic component.

### Citation List

### Patent Literature

Patent Literature 1: WO 2022/107307

### Summary of the Invention

### Technical Problem

An object of the present invention is to appropriately form a circuit board including an electronic component.

### Solution to Problem

In order to solve the above problems, the present description discloses a resin laminate formation device including an ejection device configured to eject a curable resin into a film shape to cover an upper surface of a component mounted in a cavity formed in a base and to cover an upper surface of the base, the component having a height dimension longer than a depth dimension of the cavity; and a planarization device configured to planarize the curable resin ejected from the ejection device at a set height which is set at a position higher than the upper surface of the component in a state of being mounted in the cavity, in which ejection of the curable resin from the ejection device and planarizing by the planarization device are repeatedly performed, whereby a resin laminate having an upper surface height with the set height is formed on the base by laminating the film-shaped curable resin.

**In** addition, the present description discloses a resin laminate formation method including an ejection step of ejecting a curable resin into a film shape to cover an upper surface of a component mounted in a cavity formed in a base and to cover an upper surface of the base, the component having a height dimension longer than a depth dimension of the cavity; and a planarization step of planarizing the curable resin ejected in the ejection step at a set height which is set at a position higher than the upper surface of the component in a state of being mounted in the cavity, in which ejection step and the planarization step are repeatedly performed, whereby a resin laminate having an upper surface height with the set height is formed on the base by laminating the film-shaped curable resin.

### Advantageous Effects of Invention

In the present disclosure, a cavity is formed in a base, and a component having a height dimension longer than a depth dimension of the cavity is mounted in the cavity. Then, an ejection step of ejecting a curable resin into a film shape to cover an upper surface of the component and an upper surface of the base and a planarization step of planarizing the curable resin at a set height which is set at a position higher than the upper surface of the component in a state of being mounted in the cavity are repeatedly performed. As a result, a resin laminate having an upper surface height with a set height is formed on the base by laminating the film-shaped curable resin, thus a circuit board including an electronic component can be appropriately formed.

### Brief Description of Drawings

Fig. 1 is a diagram illustrating a circuit formation device.
Fig. 2 is a block diagram illustrating a control device.
Fig. 3 is a cross-sectional view illustrating a circuit board in a state in which a resin laminate is formed.
Fig. 4 is a cross-sectional view illustrating the circuit board in a state in which a wiring line is formed on the resin laminate.
Fig. 5 is a cross-sectional view illustrating the circuit board in a state in which a second layer of resin laminate is further formed on the resin laminate.
Fig. 6 is a cross-sectional view illustrating the circuit board in a state in which a conductive paste is applied onto the wiring line.
Fig. 7 is a cross-sectional view illustrating the circuit board in a state in which an electronic component is mounted.
Fig. 8 is a cross-sectional view illustrating the circuit board in a state in which a thermosetting resin is ejected into a cavity.
Fig. 9 is a cross-sectional view illustrating the circuit board in a state in which a third layer of resin laminate is further formed on the second layer of resin laminate.
Fig. 10 is a cross-sectional view illustrating the circuit board having an air reservoir.
Fig. 11 is a schematic diagram of an ejection step of ejecting an ultraviolet curable resin onto the resin laminate, the electronic component, and the thermosetting resin.
Fig. 12 is a schematic view of a planarization step by the planarization device at set height H after the ejection step in Fig. 11 is performed.
Fig. 13 is a schematic view of the ejection step after the ejection step and the planarization step are repeatedly performed.
Fig. 14 is a schematic view of the planarization step after the ejection step in Fig. 13 is performed.
Fig. 15 is a schematic view of the ejection step after the ejection step and the planarization step are repeatedly performed.
Fig. 16 is a schematic view of the planarization step after the ejection step in Fig. 15 is performed.
Fig. 17 is a schematic view of the ejection step after the ejection step and the planarization step are repeatedly performed.
Fig. 18 is a schematic view of the planarization step after the ejection step in Fig. 17 is performed.
Fig. 19 is a cross-sectional view illustrating the circuit board including the electronic component in the third layer of resin laminate.

### Description of Embodiments

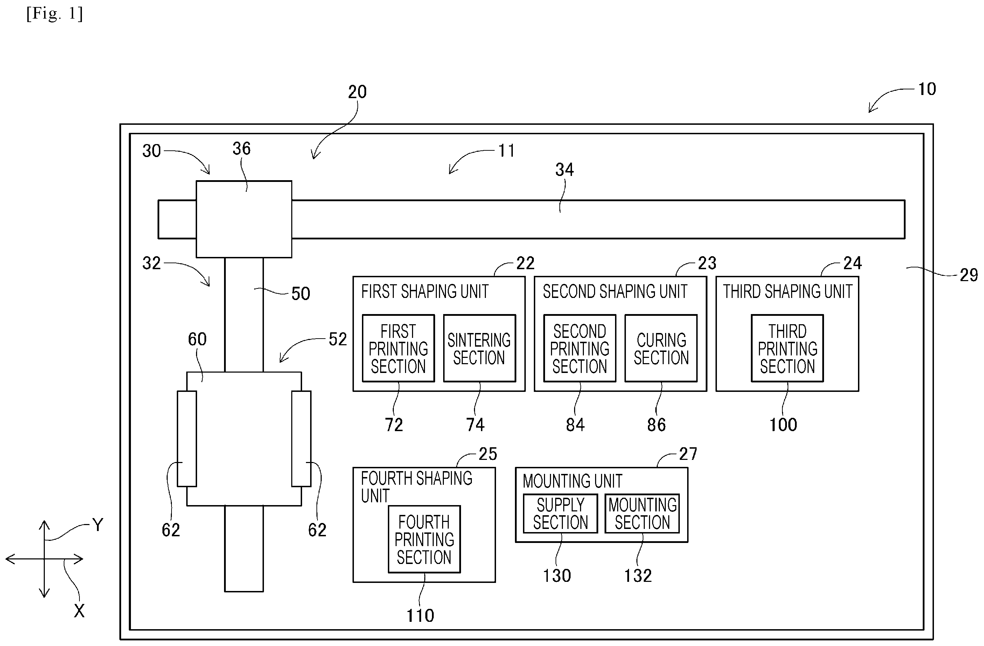

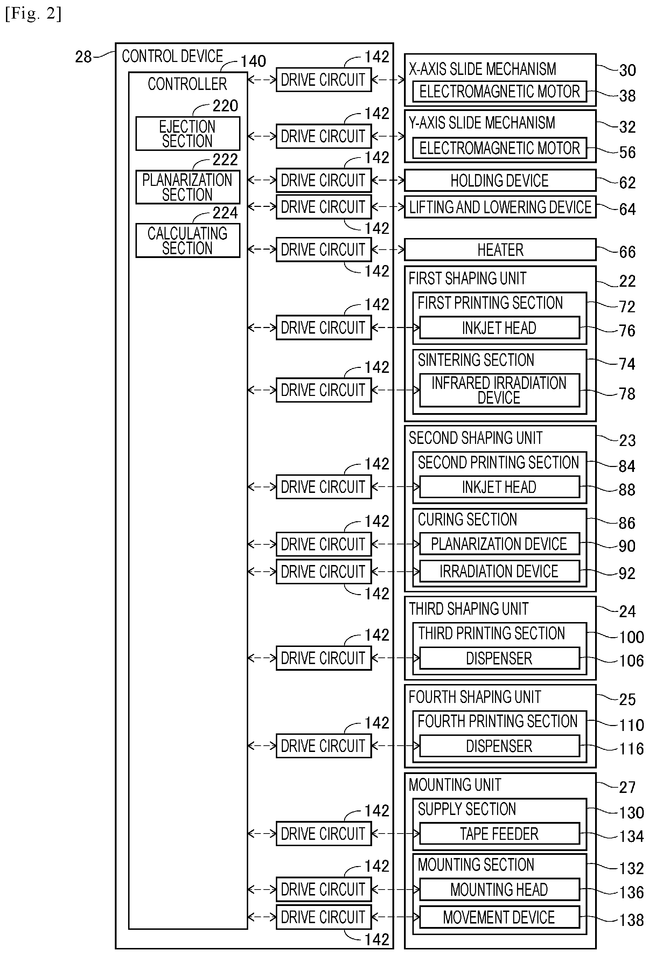

Fig. 1 illustrates an example of circuit formation device 10. Circuit formation device 10 includes conveyance device 20, first shaping unit 22, second shaping unit 23, third shaping unit 24, fourth shaping unit 25, mounting unit 27, and control device (refer to Fig. 2) 28. Conveyance device 20, first shaping unit 22, second shaping unit 23, third shaping unit 24, fourth shaping unit 25, and mounting unit 27 are disposed on base 29 of circuit formation device 10. Base 29 is generally rectangular in shape, and in the following description, a longitudinal direction of base 29 will be referred to as an X-axis direction, a transverse direction of base 29 will be referred to as a Y-axis direction, and a direction orthogonal to both the X-axis direction and the Y-axis direction will be referred to as a Z-axis direction.

Conveyance device 20 includes X-axis slide mechanism 30 and Y-axis slide mechanism 32. X-axis slide mechanism 30 includes X-axis slide rail 34 and X-axis slider 36. X-axis slide rail 34 is disposed on base 29 to extend in the X-axis direction. X-axis slider 36 is held by X-axis slide rail 34 to be slidable in the X-axis direction. Further, X-axis slide mechanism 30 includes electromagnetic motor (refer to Fig. 2) 38, and X-axis slider 36 moves to any position in the X-axis direction by the drive of electromagnetic motor 38. In addition, Y-axis slide mechanism 32 includes Y-axis slide rail 50 and stage 52. Y-axis slide rail 50 is disposed on base 29 to extend in the Y-axis direction and is movable in the X-axis direction. One end part of Y-axis slide rail 50 is coupled to X-axis slider 36. Stage 52 is held on Y-axis slide rail 50 to be slidable in the Y-axis direction. Furthermore, Y-axis slide mechanism 32 includes electromagnetic motor (refer to Fig. 2) 56, and stage 52 moves to any position in the Y-axis direction by the drive of electromagnetic motor 56. As a result, stage 52 moves to any position on base 29 by the drive of X-axis slide mechanism 30 and Y-axis slide mechanism 32.

Stage 52 includes base plate 60, holding device 62, lifting and lowering device (refer to Fig. 2) 64, and heater (refer to Fig. 2) 66. Base plate 60 is formed in a flat plate shape, and a board is placed on an upper surface thereof. Holding device 62 is provided on both side parts of base plate 60 in the X-axis direction. Both edge parts of the board placed on base plate 60 in the X-axis direction are sandwiched by holding device 62, thereby fixedly holding the board. In addition, lifting and lowering device 64 is disposed below base plate 60 to lift and lower base plate 60. Further, heater 66 is incorporated into base plate 60 and heats the board placed on base plate 60 to any temperature.

First shaping unit 22 is a unit that shapes a wiring line of a circuit board, and includes first printing section 72 and sintering section 74. First printing section 72 includes inkjet head (refer to Fig. 2) 76, and inkjet head 76 linearly ejects metal ink. The metal ink is metal ink in which nanometer-sized metal fine particles, for example, silver fine particles, are dispersed in a solvent. Surfaces of the metal fine particles are coated with a dispersant to prevent aggregation in the solvent. Additionally, inkjet head 76 ejects the metal ink from multiple nozzles through, for example, a piezoelectric method using a piezoelectric element.

Sintering section 74 includes infrared irradiation device (refer to Fig. 2) 78. Infrared irradiation device 78 is a device that irradiates the ejected metal ink with infrared rays. The metal ink irradiated with the infrared rays is subjected to sintering, thereby forming the wiring line. Sintering of the metal ink is a phenomenon in which applying energy causes the solvent to evaporate, the protective films of the metal fine particles, that is, the dispersant, to break down, or the like so that the metal fine particles come into contact with or fuse each other, thereby increasing the conductivity. The metal ink is sintered to form a metal wiring line.

In addition, second shaping unit 23 is a unit that shapes a resin layer of the circuit board, and includes second printing section 84 and curing section 86. Second printing section 84 includes inkjet head (refer to Fig. 2) 88, and inkjet head 88 ejects an ultraviolet curable resin. The ultraviolet curable resin is a resin to be cured by irradiation with ultraviolet rays. Inkjet head 88 may employ, for example, a piezoelectric method using the piezoelectric element, or may be a thermal type in which the resin is heated to generate bubbles which is ejected from multiple nozzles.

Curing section 86 includes planarization device (refer to Fig. 2) 90 and irradiation device (refer to Fig. 2) 92. Planarization device 90 planarizes an upper surface of the ultraviolet curable resin ejected by inkjet head 88, and makes a thickness of the ultraviolet curable resin uniform by, for example, evening out the surface of the ultraviolet curable resin while scraping off an excess resin with a roller or a blade. Additionally, irradiation device 92 includes a mercury lamp or an LED as a light source and irradiates the ejected ultraviolet curable resin with ultraviolet rays. In this manner, the ejected ultraviolet curable resin is cured to form a resin layer.

Third shaping unit 24 is a unit that shapes a connection section between an electrode of the electronic component and the wiring line on the circuit board, and includes third printing section 100. Third printing section 100 includes dispenser (refer to Fig. 2) 106, and dispenser 106 ejects conductive paste. The conductive paste is a conductive paste in which micrometer-sized metal particles are dispersed in a resin to be cured by relatively low-temperature heating. Incidentally, the metal particles have a flake shape, and viscosity of the conductive paste is relatively higher compared to that of the metal ink. The amount of the conductive paste ejected from dispenser 106 is controlled by an inner diameter of a needle, a pressure during ejection, and an ejection time.

The conductive paste ejected by dispenser 106 is heated by heater 66 incorporated into base plate 60. In the heated conductive paste, the resin is cured. At this time, in the conductive paste, the resin is cured and contracted, and the dispersed flake-shaped metal particles come into contact with the resin. Consequently, the conductive paste exhibits conductivity. In addition, the resin of the conductive paste is an organic adhesive, and exhibits an adhesive force when cured by heating.

Fourth shaping unit 25 is a unit that shapes a resin for fixing the electronic component to the circuit board, and includes fourth printing section 110. Fourth printing section 110 includes dispenser (refer to Fig. 2) 116, and dispenser 116 ejects a thermosetting resin. The thermosetting resin is a resin to be cured by heating. Dispenser 116 employs, for example, a piezoelectric method using a piezoelectric element. The thermosetting resin ejected from dispenser 116 is heated by heater 66 incorporated into base plate 60 and is cured.

Additionally, mounting unit 27 is a unit that mounts the electronic component on the circuit board, and includes supply section 130 and mounting section 132. Supply section 130 includes multiple tape feeders (refer to Fig. 2) 134 that feed taped electronic components one by one, and supplies the electronic component at a supply position. Supply section 130 is not limited to tape feeder 134 and may be a tray type supply device that supplies the electronic component by picking up the electronic component from a tray. Alternatively, supply section 130 may include both the tape type supply device and the tray type supply device, or other supply devices.

Mounting section 132 includes mounting head (refer to Fig. 2) 136 and movement device (refer to Fig. 2) 138. Mounting head 136 includes a suction nozzle (not illustrated) for picking up and holding the electronic component. The suction nozzle picks up and holds the electronic component by suctioning air through the supply of a negative pressure from a positive and negative pressure supply device (not illustrated). By supplying a slight positive pressure from the positive and negative pressure supply device, the electronic component is released. Additionally, movement device 138 moves mounting head 136 between the supply position of the electronic component by tape feeder 134 and the board placed on base plate 60. Consequently, in mounting section 132, the electronic component supplied from tape feeder 134 is held by the suction nozzle, and the electronic component held by the suction nozzle is mounted on the board.

In addition, control device 28 includes controller 140 and multiple drive circuits 142, as illustrated in Fig. 2. Multiple drive circuits 142 are connected to electromagnetic motors 38 and 56, holding device 62, lifting and lowering device 64, heater 66, inkjet head 76, infrared irradiation device 78, inkjet head 88, planarization device 90, irradiation device 92, dispenser 106, dispenser 116, tape feeder 134, mounting head 136, and movement device 138. Controller 140 includes CPU, ROM, RAM, or the like, mainly includes a computer, and is connected to multiple drive circuits 142. As a result, the operations of conveyance device 20, first shaping unit 22, second shaping unit 23, third shaping unit 24, fourth shaping unit 25, and mounting unit 27 are controlled by controller 140.

With the configuration described above, in circuit formation device 10, a resin laminate is formed on base plate 60, and a wiring line is formed on an upper surface of the resin laminate. Then, the electrodes of the electronic component are electrically connected to the wiring line via the conductive paste, and the electronic component is fixed by the resin. Further, a second resin laminate is formed to cover the resin laminate and the electronic component to form a circuit board.

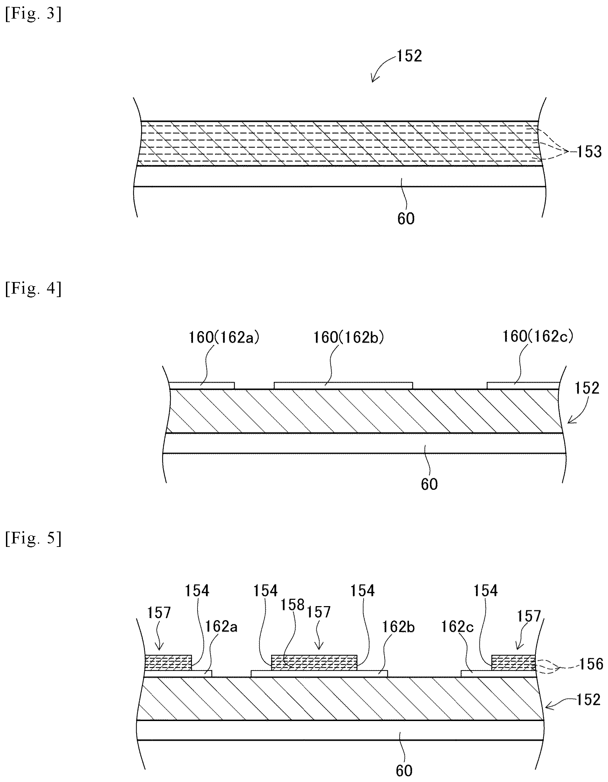

Specifically, first, stage 52 is moved below second shaping unit 23. Then, in second shaping unit 23, as illustrated in Fig. 3, resin laminate 152 is formed on base plate 60 of stage 52. Resin laminate 152 is formed by repeatedly ejecting the ultraviolet curable resin from inkjet head 88 and irradiating the ejected ultraviolet curable resin with ultraviolet rays from irradiation device 92.

In detail, in second printing section 84 of second shaping unit 23, inkjet head 88 ejects the ultraviolet curable resin in a thin film shape onto the upper surface of base plate 60. Subsequently, when the ultraviolet curable resin is ejected in a thin film shape, in curing section 86, the ultraviolet curable resin is planarized by planarization device 90 such that the ultraviolet curable resin has a uniform film thickness. Then, irradiation device 92 irradiates the thin film-shaped ultraviolet curable resin with ultraviolet rays. As a result, thin film-shaped resin layer 153 is formed on base plate 60.

Subsequently, inkjet head 88 ejects the ultraviolet curable resin in a thin film shape onto thin film-shaped resin layer 153. The thin film-shaped ultraviolet curable resin is planarized by planarization device 90, irradiation device 92 irradiates the ultraviolet curable resin ejected in a thin film shape with ultraviolet rays, thereby laminating thin film-shaped resin layer 153 on thin film-shaped resin layer 153. In this manner, by repeatedly ejecting the ultraviolet curable resin onto thin film-shaped resin layer 153 and irradiating the ultraviolet curable resin with ultraviolet rays and by laminating multiple resin layers 153, resin laminate 152 is formed.

Next, when resin laminate 152 is formed, stage 52 is moved below first shaping unit 22. Then, in first printing section 72 of first shaping unit 22, as illustrated in Fig. 4, inkjet head 76 linearly ejects metal ink 160 on an upper surface of resin laminate 152 in accordance with a circuit pattern. Subsequently, infrared irradiation device 78 irradiates metal ink 160 ejected in accordance with the circuit pattern with infrared rays in sintering section 74 of first shaping unit 22. Consequently, metal ink 160 is subjected to sintering, thereby forming wiring line 162 on the upper surface of resin laminate 152. In Fig. 4, three wiring lines 162 are formed, but in a case where three wiring lines 162 are distinguished from each other, the wiring line on the left side in Fig. 4 will be described as wiring line 162a, the wiring line at the center will be described as wiring line 162b, and the wiring line on the right side will be described as wiring line 162c.

Subsequently, when wiring line 162 is formed on resin laminate 152, stage 52 is moved below second shaping unit 23. Then, in second shaping unit 23, inkjet head 88 ejects the ultraviolet curable resin in a thin film shape such that end parts of three wiring lines 162 are exposed. Subsequently, when the ultraviolet curable resin is ejected in a thin film shape, in curing section 86, the ultraviolet curable resin is planarized such that the ultraviolet curable resin has a uniform film thickness. Then, irradiation device 92 irradiates the thin film-shaped ultraviolet curable resin with ultraviolet rays. As a result, as illustrated in Fig. 5, resin layer 156 is formed on resin laminate 152.

Subsequently, inkjet head 88 ejects the ultraviolet curable resin in a thin film shape only onto a portion on resin layer 156. That is, inkjet head 88 ejects the ultraviolet curable resin in a thin film shape onto resin layer 156 such that the end parts of three wiring lines 162 are exposed. The thin film-shaped ultraviolet curable resin is planarized by planarization device 90, and irradiation device 92 irradiates the ultraviolet curable resin ejected in a thin film shape with ultraviolet rays, thereby laminating resin layer 156 on resin layer 156. In this manner, by repeatedly ejecting the ultraviolet curable resin onto resin layer 156 and irradiating the ultraviolet curable resin with ultraviolet rays and by laminating multiple resin layers 156, resin laminate 157 is formed. As a result, resin laminate 157 is formed on resin laminate 152, and a step portion between resin laminate 152 and resin laminate 157 functions as cavity 154.

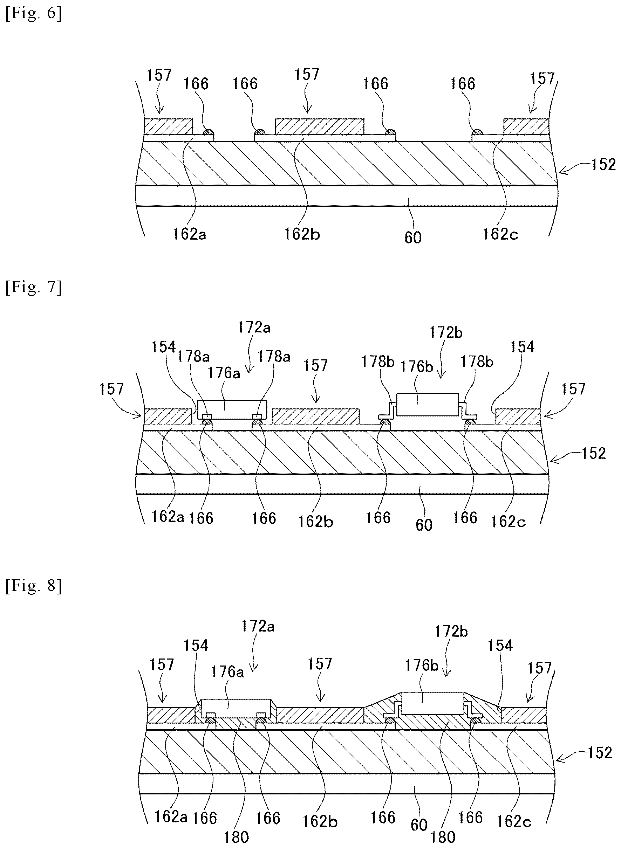

When resin laminate 157 is formed on resin laminate 152 in this manner, stage 52 is moved below third shaping unit 24. In third printing section 100 of third shaping unit 24, as illustrated in Fig. 6, dispenser 106 ejects conductive paste 166 onto both end parts of wiring line 162b, and onto end parts of wiring line 162a and wiring line 162c that face both end parts of wiring line 162b.

When conductive paste 166 is ejected onto the end part of wiring line 162 in this manner, resin laminate 152 is heated by heater 66 incorporated into base plate 60 in accordance with a heating condition of the conductive paste. Thus, conductive paste 166 is heated and cured through resin laminate 152, thereby exhibiting conductivity.

When conductive paste 166 ejected onto the end part of wiring line 162 is cured by heating in this manner, stage 52 is moved below mounting unit 27. In mounting unit 27, electronic component (refer to Fig. 7) 172 is supplied by tape feeder 134, and electronic component 172 is held by the suction nozzle of mounting head 136. Electronic component 172 includes component main body 176 and two electrodes 178. Mounting head 136 is moved by movement device 138, and electronic component 172 held by the suction nozzle is mounted on the upper surface of resin laminate 152 in cavity 154 as illustrated in Fig. 7. In Fig. 7, two electronic components 172 are mounted on the upper surface of resin laminate 152. In one electronic component 172a of two electronic components 172, two electrodes 178a are disposed on the lower surface of component main body 176a. In other electronic component 172b of two electronic components 172, two electrodes 178b extend laterally from a pair of opposing side surfaces of component main body 176b, and then extend downward. Two electronic components 172a and 172b are mounted on the upper surface of resin laminate 152 such that electronic component 172a is electrically connected to two wiring lines 162a and 162b and electronic component 172b is electrically connected to two wiring lines 162b and 162c.

Specifically, electronic component 172a is mounted such that a lower surface of electrode 178a comes into contact with conductive paste 166, which has been cured on wiring lines 162a and 162b. Additionally, electronic component 172b is mounted such that a distal end of electrode 178 comes into contact with conductive paste 166, which has been cured on wiring lines 162b and 162c. That is, conductive paste 166 is ejected to the position where electrode 178 is to be mounted on wiring line 162, and electronic component 172 is mounted on resin laminate 152, thereby electrode 178 comes into contact with conductive paste 166, which has been cured on wiring line 162. In this manner, by mounting two electronic components 172a and 172b, electronic component 172a is electrically connected to two wiring lines 162a and 162b, and electronic component 172b is electrically connected to two wiring lines 162b and 162c.

A height dimension of electronic component 172a is longer than a depth dimension of cavity 154 in which electronic component 172a is mounted. Therefore, the upper surface of component main body 176a of electronic component 172a mounted in cavity 154 extends upward from cavity 154. That is, the upper surface of component main body 176a of electronic component 172a is positioned higher than the upper surface of resin laminate 157 partitioning cavity 154. A height dimension of electronic component 172b is also longer than the depth dimension of cavity 154 in which electronic component 172b is mounted. Therefore, the upper surface of component main body 176a of electronic component 172b mounted in cavity 154 also extends upward from cavity 154. That is, the upper surface of component main body 176b of electronic component 172b is also positioned higher than the upper surface of resin laminate 157 partitioning cavity 154. Therefore, a height dimension of resin laminate 157 is set to be lower than a height dimension of electronic component 172 to be mounted such that the upper surface of component main body 176 of electronic component 172 is positioned higher than the upper surface of resin laminate 157. The height dimension of electronic component 172b is longer than the height dimension of electronic component 172a. The depth dimension of cavity 154 in which electronic component 172a is mounted is the same as the depth dimension of cavity 154 in which electronic component 172b is mounted. Therefore, the upper surface of electronic component 172b in a state of being mounted in cavity 154 is positioned higher than the upper surface of electronic component 172a in a state of being mounted in cavity 154. That is, at the time when electronic component 172 is mounted in cavity 154, the upper surface of electronic component 172b is positioned at the highest level.

Subsequently, stage 52 is moved below fourth shaping unit 25. In fourth printing section 110 of fourth shaping unit 25, dispenser 116 ejects thermosetting resin 180 between the lower surface of component main body 176 of electronic component 172 and the upper surface of resin laminate 152, as illustrated in Fig. 8. As a result, thermosetting resin 180 is sealed between the upper surface of resin laminate 152 and the lower surface of component main body 176 of electronic component 172. That is, thermosetting resin 180 is injected between the upper surface of resin laminate 152 and the lower surface of component main body 176. At this time, thermosetting resin 180 flows out from between the upper surface of resin laminate 152 and the lower surface of component main body 176 to a periphery of electronic component 172, and fills the inside of cavity 154. At this time, thermosetting resin 180 fills the entire interior of cavity 154 and is ejected to closely contact the side surface of component main body 176 of electronic component 172. When thermosetting resin 180 is thus ejected into cavity 154, thermosetting resin 180 is heated by heater 66 incorporated into base plate 60 in accordance with the heating condition of the thermosetting resin. Consequently, thermosetting resin 180 is heated and cured through resin laminate 152.

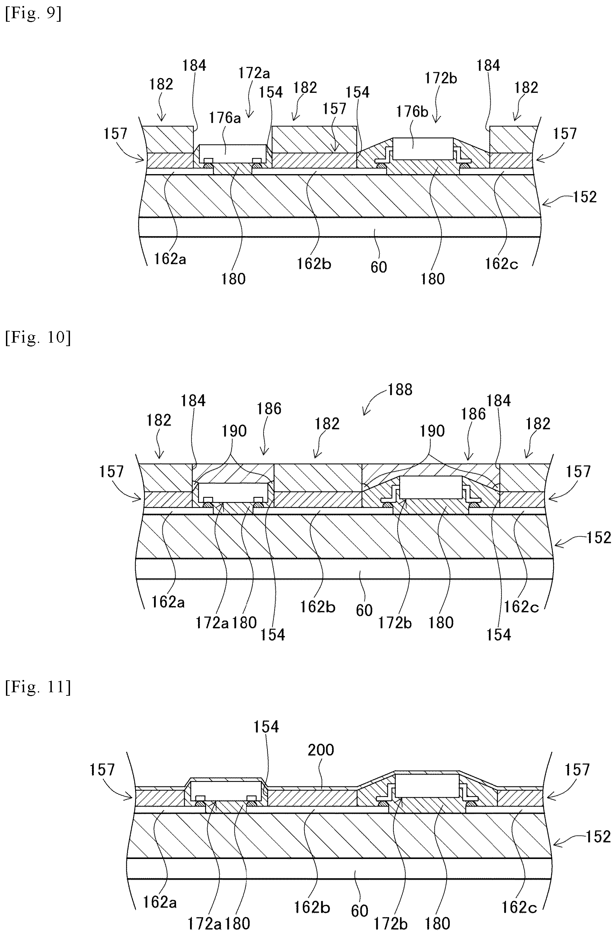

Subsequently, when thermosetting resin 180 ejected into cavity 154 is cured, stage 52 is moved below second shaping unit 23. In second shaping unit 23, as illustrated in Fig. 9, resin laminate 182 is formed on resin laminate 157. Resin laminate 182 is formed by the same method as resin laminate 157. That is, resin laminate 182 is formed by repeating the ejection of the ultraviolet curable resin toward the upper side of resin laminate 157, the planarizing of the surface of the ultraviolet curable resin, and the curing of the ultraviolet curable resin. Since the ultraviolet curable resin is not ejected into cavity 154 of resin laminate 157 during formation of resin laminate 182, cavity 184 continuous from cavity 154 of resin laminate 157 is formed in resin laminate 182. The height dimension of resin laminate 182 is set such that the upper surface of resin laminate 182 is positioned higher than the upper surface of electronic component 172b.

When resin laminate 182 is formed, as shown in Fig. 10, resin laminate 186 is formed inside cavity 184 of resin laminate 182. Resin laminate 186 is formed by the same method as resin laminate 157. That is, resin laminate 186 is formed by repeating the ejection of the ultraviolet curable resin toward the inside of cavity 184 of resin laminate 157, the planarizing of the surface of the ultraviolet curable resin, and the curing of the ultraviolet curable resin. The height dimension of resin laminate 186 is the same as the height dimension of resin laminate 182. Accordingly, the ultraviolet curable resin is ejected to cover cavity 184 and entire electronic component 172, and resin laminate 186 containing entire electronic component 172 is formed. Thus, resin laminate 186 including entire electronic component 172 is formed inside cavity 184, so that circuit board 188 is formed. In such circuit board 188, since electronic component 172 is encapsulated in resin laminate 186, electronic component 172 can be sealed in circuit board 188 to prevent foreign matter from entering electronic component 172. In addition, for example, a wiring line or the like can be further formed on the upper surfaces of resin laminate 186 and resin laminate 182, the electronic component can be mounted, and many electronic components can be mounted on the circuit board.

However, in circuit board 188, air reservoir 190 may be formed inside cavity 184, specifically between the wall surface of resin laminate 182 partitioning cavity 184, thermosetting resin 180, and resin laminate 186. This is because when the ultraviolet curable resin is ejected into cavity 184, in particular, a vicinity of the wall surface of resin laminate 182 partitioning cavity 184, liquid droplets of the ultraviolet curable resin collide with the wall surface of resin laminate 182. That is, the liquid droplets of the ultraviolet curable resin ejected toward the vicinity of the wall surface of resin laminate 182 partitioning cavity 184 collide with the wall surface of resin laminate 182, the ultraviolet curable resin is not ejected to the vicinity of the wall surface of resin laminate 182, and air reservoir 190 is formed the vicinity of the wall surface of resin laminate 182. As described above, in circuit board 188 in which air reservoir 190 is formed, the air is repeatedly expanded and contracted due to the temperature change in air reservoir 190, so that the load may be applied to electronic component 172 and the reliability of circuit board 188 may be decreased.

In circuit formation device 10, after thermosetting resin 180 is formed in cavity 154, resin laminate including electronic component 172 is formed by repeating the ejection step of ejecting the ultraviolet curable resin to cover electronic component 172 and resin laminate 157, the planarization step at the set height which is set at a position higher than the upper surface of electronic component 172b, and the irradiation step with ultraviolet rays. Specifically, as shown in Fig. 8, after thermosetting resin 180 is formed in cavity 154 in which electronic component 172 is mounted, stage 52 is moved below second shaping unit 23. Then, in second shaping unit 23, as shown in Fig. 11, inkjet head 88 ejects ultraviolet curable resin 200 to cover the upper surface of electronic component 172 and also cover the upper surface of resin laminate 157. At this time, inkjet head 88 ejects ultraviolet curable resin 200 not only to electronic component 172 and resin laminate 157 but also to the upper surface of thermosetting resin 180 formed in cavity 154 of resin laminate 157. That is, inkjet head 88 ejects ultraviolet curable resin 200 in a thin film shape to cover the entire upper surfaces of electronic component 172, resin laminate 157, and thermosetting resin 180.

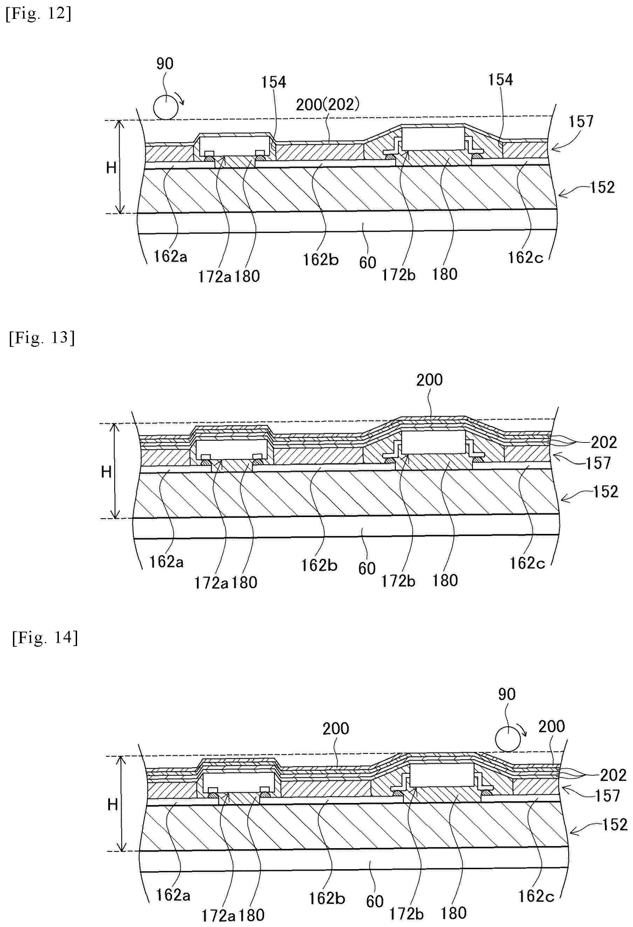

Next, in second shaping unit 23, as illustrated in Fig. 12, planarization device 90, for example, a roller operates at set height H. Set height H is, for example, a height with the upper surface of base plate 60 as the reference, and corresponds to a thickness of the circuit board to be formed. Set height H is set to a position higher than the upper surface of electronic component 172 at the highest position among multiple electronic components 172 mounted in cavity 154, that is, the upper surface of electronic component 172b. Planarization device 90 is operated at set height H, but ultraviolet curable resin 200 ejected to cover the entire upper surfaces of electronic component 172, resin laminate 157, and thermosetting resin 180 does not reach set height H. Therefore, planarization device 90 passes above ultraviolet curable resin 200 without contacting ultraviolet curable resin 200, that is, without planarizing ultraviolet curable resin 200. Then, after planarization device 90 is operated at set height H, irradiation device 92 irradiates ultraviolet curable resin 200 with ultraviolet rays. As a result, single-layer resin layer 202 covering the upper surfaces of electronic component 172, resin laminate 157, and thermosetting resin 180 is formed. Since an upper surface height of electronic component 172, an upper surface height of resin laminate 157, and an upper surface height of thermosetting resin 180 are different from each other, resin layer 202 having an uneven shape is formed.

Then, the ejection step of ultraviolet curable resin 200, the planarization step at set height H, and the irradiation step with ultraviolet rays are repeated multiple times, for example, three times, whereby three-layer resin layer 202 is formed to cover the upper surfaces of electronic component 172, resin laminate 157, and thermosetting resin 180. Since the height of the upper surface of the third layer of resin layer 202 has not reached set height H, when the ejection step, the planarization step, and the irradiation step are repeated three times, planarization device 90 does not planarize ultraviolet curable resin 200. When the fourth ejection step is performed, as shown in Fig. 13, ultraviolet curable resin 200 is ejected onto the third layer of resin layer 202. The height of the upper surface of ultraviolet curable resin 200 ejected in the fourth ejection step exceeds set height H. Therefore, in the fourth planarization step, as shown in Fig. 14, ultraviolet curable resin 200 is planarized by planarization device 90. Before the ultraviolet curable resin is ejected onto the upper surfaces of electronic component 172, resin laminate 157, and thermosetting resin 180 (refer to Fig. 8), the upper surface of electronic component 172b is positioned at the highest level. Therefore, in ultraviolet curable resin 200 ejected in the fourth ejection step, only ultraviolet curable resin 200 ejected above the upper surface of electronic component 172b exceeds set height H, and only ultraviolet curable resin 200 ejected above the upper surface of electronic component 172b is planarized by planarization device 90. Then, irradiation device 92 irradiates ultraviolet curable resin 200 with the ultraviolet rays to cure planarized ultraviolet curable resin 200 to form resin layer 202.

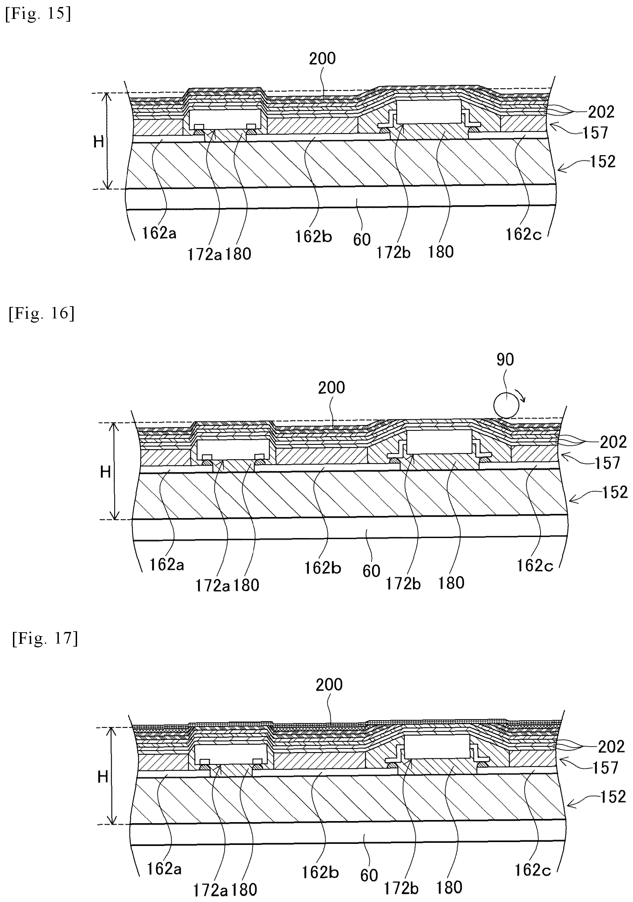

Further, after the ejection step of ultraviolet curable resin 200, the planarization step at set height H, and the irradiation step with ultraviolet rays are repeated multiple times, the ejection step of ultraviolet curable resin 200 performed, as illustrated in Fig. 15, whereby the upper surface height of ejected ultraviolet curable resin 200 exceeds set height H. Before the ultraviolet curable resin is ejected onto the upper surfaces of electronic component 172, resin laminate 157, and thermosetting resin 180 (refer to Fig. 8), the upper surface of electronic component 172a is the next highest after the upper surface of electronic component 172b. Therefore, as illustrated in Fig. 15, ultraviolet curable resin 200 ejected above the upper surfaces of electronic component 172a and electronic component 172b exceeds set height H. Since a part of thermosetting resin 180 around electronic component 172b is higher than the upper surface of electronic component 172a, a part of ultraviolet curable resin 200 ejected above thermosetting resin 180 around electronic component 172b also exceeds set height H. By operating planarization device 90 at set height H with respect to ultraviolet curable resin 200 ejected as described above, as illustrated in Fig. 16, ultraviolet curable resin 200 ejected above the upper surfaces of electronic components 172a and 172b and a part of ultraviolet curable resin 200 ejected above thermosetting resin 180 around electronic component 172b are planarized by planarization device 90. Then, irradiation device 92 irradiates ultraviolet curable resin 200 with the ultraviolet rays to cure planarized ultraviolet curable resin 200 to form resin layer 202.

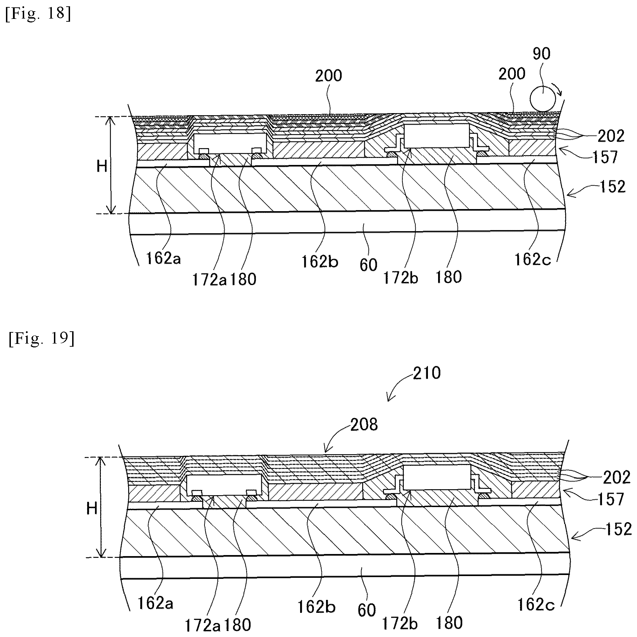

Subsequently, after the ejection step of ultraviolet curable resin 200, the planarization step at set height H, and the irradiation step with ultraviolet rays are repeated multiple times, the ejection step of ultraviolet curable resin 200 performed, as illustrated in Fig. 17, whereby the upper surface height of ejected ultraviolet curable resin 200 exceeds set height H. In addition, before the ultraviolet curable resin is ejected onto the upper surfaces of electronic component 172, resin laminate 157, and thermosetting resin 180 (refer to Fig. 8), the upper surface of resin laminate 157 is the lowest; however, ultraviolet curable resin 200 ejected above the upper surface of resin laminate 157 also exceeds set height H. That is, ultraviolet curable resin 200 ejected above all of electronic component 172, thermosetting resin 180, and resin laminate 157 exceeds set height H. By operating planarization device 90 at set height H with respect to ultraviolet curable resin 200 ejected as described above, as illustrated in Fig. 18, ultraviolet curable resin 200 ejected above all of electronic component 172, thermosetting resin 180, and resin laminate 157 is planarized by planarization device 90. Then, irradiation device 92 irradiates ultraviolet curable resin 200 with the ultraviolet rays to cure planarized ultraviolet curable resin 200 to form resin layer 202. In this way, by planarizing and curing ultraviolet curable resin 200 ejected above all of electronic component 172, thermosetting resin 180, and resin laminate 157, multiple layers of resin layers 202 are laminated, and as illustrated in Fig. 19, resin laminate 208 having an upper surface height with set height H is formed. As described above, set height H is set at a position higher than the upper surface of electronic component 172b that is at the highest position among the multiple electronic components 172 mounted in cavity 154, whereby the entire set of all multiple electronic components 172 is encapsulated by resin laminate 208. In this way, circuit board 210 is formed by forming resin laminate 208 including entire set of all multiple electronic components 172 on resin laminate 157. In such circuit board 210, during formation of resin laminate 208, the ultraviolet curable resin is ejected onto the entire upper surfaces of electronic component 172, resin laminate 157, and thermosetting resin 180 and is planarized by planarization device 90 at set height H. Thus, unlike the conventional case, the ultraviolet curable resin is not ejected to the vicinity of the wall surface of the resin laminate partitioning the cavity. Therefore, circuit board 210 having no air reservoir can be formed, and highly reliable circuit board 210 can be formed.

As described above, resin laminate 208 is formed by laminating multiple resin layers 202 by repeating ejection step of ultraviolet curable resin 200, the planarization step at set height H, and the irradiation step with ultraviolet rays multiple times, and resin layer 202, that is, the number of laminated layers of ultraviolet curable resin 200 is calculated based on set height H. Specifically, resin laminate 208 is formed on the upper surface of electronic component 172, resin laminate 157, and thermosetting resin 180, and the height of the upper surface of resin laminate 208 is set height H. The lowest surface of the upper surfaces of electronic component 172, resin laminate 157, and thermosetting resin 180 is the upper surface of resin laminate 157. Therefore, a thickness dimension of the thickest portion of resin laminate 208 is a thickness dimension of resin laminate 208 formed on the upper surface of resin laminate 157. Here, when the upper surface height of resin laminate 157 is set as H1 with the upper surface of base plate 60 as the reference, the thickness dimension of the thickest portion of resin laminate 208 is (H - H1). When a film pressure of ultraviolet curable resin 200 ejected in a thin film shape from inkjet head 88 is set as α, the number of laminated layers of ultraviolet curable resin 200 is (H - H1)/α. By repeating the ejection step of ultraviolet curable resin 200, the planarization step at set height H, and the irradiation step with ultraviolet rays for the calculated number of laminated layers, the calculated number of laminated layers of resin layers 202 are laminated to form resin laminate 208.

As illustrated in Fig. 2, controller 140 of control device 28 includes ejection section 220, planarization section 222, and calculating section 224. Ejection section 220 is a functional section for ejecting ultraviolet curable resin 200 in a thin film shape during formation of resin laminate 208. Planarization section 222 is a functional section for planarizing ultraviolet curable resin 200 ejected from ejection section 220 at set height H. Calculating section 224 is a functional section for calculating the number of laminated layers of resin layers 202 of resin laminate 208.

In the above example, second shaping unit 23 is an example of a resin laminate formation device. Inkjet head 88 is an example of an ejection device. Planarization device 90 is an example of a planarization device. Resin laminates 152 and 157 are examples of bases. The upper surface of resin laminate 157 is an example of the highest upper surface of the base. Cavity 154 is an example of a cavity. Electronic components 172a and 172b are examples of components. Ultraviolet curable resin 200 is an example of a curable resin. Resin laminate 208 is an example of a resin laminate. A step performed by ejection section 220 is an example of an ejection step. A step performed by planarization section 222 is an example of a planarization step.

The present invention is not limited to the above example and may be performed in various aspects in which various modifications and improvements are made based on the knowledge of those skilled in the art. For example, in the above example, all of two electronic components 172, that is, all of the multiple electronic components have a height dimension longer than the depth dimension of cavity 154, and the upper surface of the electronic component is higher than the upper surface of resin laminate 157 in all of the multiple electronic components. On the other hand, some of the multiple electronic components may have a height dimension longer than the depth dimension of cavity 154, and the upper surface of the electronic component may be higher than the upper surface of resin laminate 157 in some electronic components. That is, the remaining electronic components among the multiple electronic components may have a height dimension shorter than the depth dimension of cavity 154, and the upper surface of the electronic component may be lower than the upper surface of resin laminate 157 in the remaining electronic components.

In addition, in the above example, thermosetting resin 180 fills the entire interior of cavity 154 inside cavity 154 in a state in which electronic component 172 is mounted, and is ejected to be in close contact with the side surface of component main body 176 of electronic component 172. On the other hand, thermosetting resin 180 may be ejected to such a degree that electronic component 172 can be fixed even in a case where thermosetting resin 180 does not fill the entire interior of cavity 154 inside cavity 154 in a state in which electronic component 172 is mounted. In addition, thermosetting resin 180 need not be ejected into cavity 154 in a state in which electronic component 172 is mounted, and resin laminate 208 may be formed. That is, when resin laminate 208 is formed, an ejection step of ejecting ultraviolet curable resin 200 in a thin film shape onto the upper surface of resin laminate 157, onto the upper surface of electronic component 172, and into cavity 154, and planarization step at set height H may be repeatedly performed. Thus, electronic component 172 is fixed inside of cavity 154 with resin laminate 208, and is encapsulated in resin laminate 208.

In the above example, when resin laminate 208 is formed, ultraviolet curable resin 200 is ejected in a thin film shape to cover the entire upper surfaces of electronic component 172, resin laminate 157, and thermosetting resin 180. On the other hand, ultraviolet curable resin 200 may be ejected in a thin film shape excluding a part of the upper surfaces of electronic component 172, resin laminate 157, and thermosetting resin 180. In this way, by laminating resin layer 202 excluding a part of the upper surface of electronic component 172, resin laminate 157, and thermosetting resin 180, it is possible to form a resin laminate in which a part of the upper surface of electronic component 172, resin laminate 157, and thermosetting resin 180 is exposed.

Although calculating section 224 is disposed in control device 28 of circuit formation device 10, calculating section 224 may be disposed in a device different from circuit formation device 10, for example, an information processing device used for designing a circuit board. That is, the number of laminated layers of ultraviolet curable resin 200 in resin laminate 208 may be calculated in a device different from circuit formation device 10.

In addition, in the above example, the ultraviolet curable resin is adopted as the curable resin for forming resin laminate 208, but various resins such as thermosetting resin and two-liquid mixed resin may be adopted.

In the above example, electronic component 172 is mounted in cavity 154 of resin laminates 152 and 157 that function as a base, and electronic component 172 is encapsulated in resin laminate 208. On the other hand, a component other than the electronic component, for example, a component not electrically connected may be mounted in the cavity of the base, and the component may be encapsulated in resin laminate 208.

In addition, in the above example, the ultraviolet curable resin is adopted as the resin forming resin laminates 152, 157, and 208, and thermosetting resin 180 is adopted as the resin for fixing electronic component 172 inside cavity 154. However, another curable resin (for example, an ultraviolet curable resin or a two-liquid mixed resin) may be used as a resin for fixing electronic component 172 inside cavity 154. In addition, in the above example, the resin for forming resin laminates 152, 157, and 208 and the resin for fixing electronic component 172 are different curable resins, but the resin for forming resin laminates 152, 157, and 208 and the resin for fixing electronic component 172 may be the same curable resin.

### Reference Signs List

23: Second shaping unit (resin laminate formation device), 88: Inkjet head (ejection device), 90: Planarization device, 152: Resin laminate (base), 157: Resin laminate (base), 154: Cavity, 172: Electronic component (component), 200: Ultraviolet curable resin (curable resin), 208: Resin laminate, 220: Ejection section (ejection step), 222: Planarization section (planarization step).

## Claims

1. A resin laminate formation device comprising:
an ejection device configured to eject a curable resin into a film shape to cover an upper surface of a component mounted in a cavity formed in a base and to cover an upper surface of the base, the component having a height dimension longer than a depth dimension of the cavity; and
a planarization device configured to planarize the curable resin ejected from the ejection device at a set height which is set at a position higher than the upper surface of the component in a state of being mounted in the cavity,
wherein ejection of the curable resin from the ejection device and planarizing by the planarization device are repeatedly performed, whereby a resin laminate having an upper surface height with the set height is formed on the base by laminating the film-shaped curable resin.

2. The resin laminate formation device according to Claim 1, wherein
the set height in a state where multiple components are mounted in multiple cavities formed in the base is a position higher than an upper surface of a component at the highest position among the multiple components in a state of being mounted in the respective cavities.

3. The resin laminate formation device according to Claim 2, wherein
the component to be mounted in each of the multiple cavities has the height dimension longer than the depth dimension of each cavity.

4. The resin laminate formation device according to any one of Claims 1 to 3, wherein
the number of laminated layers of the film-shaped curable resin in the resin laminate is calculated based on a difference between a height of the highest upper surface of the base and the set height, and
the ejection of the curable resin from the ejection device and the planarizing by the planarization device are repeatedly performed for the calculated number of the laminated layers, whereby the film-shaped curable resin having the calculated number of laminated layers is laminated to form the resin laminate.

5. A resin laminate formation method comprising:
an ejection step of ejecting a curable resin into a film shape to cover an upper surface of a component mounted in a cavity formed in a base and to cover an upper surface of the base, the component having a height dimension longer than a depth dimension of the cavity; and
a planarization step of planarizing the curable resin ejected in the ejection step at a set height which is set at a position higher than the upper surface of the component in a state of being mounted in the cavity,
wherein the ejection step and the planarization step are repeatedly performed, whereby a resin laminate having an upper surface height with the set height is formed on the base by laminating the film-shaped curable resin.
